# EUROPEAN PATENT APPLICATION

(11) **EP 4 446 764 A1**
(43) Date of publication of application: **16.10.2024**
(21) Application number: 23807811.7
(22) Date of filing: 28.04.2023
(51) Int. Cl.: G01R 31/392, G01R 31/36, G01R 19/165, G01R 19/10, G01R 19/12, H01M 10/0525, H01M 10/48

(54) **BATTERY STATE MANAGEMENT DEVICE AND OPERATION METHOD THEREOF**

(30) Priority: 18.05.2022 KR 20220060637
(71) Applicant: LG Energy Solution, Ltd., Seoul 07335 (KR)
(72) Inventor: KIM, Young Jin, Daejeon 34122 (KR)
(74) Representative: Plasseraud IP
(86) International application number: PCT/KR2023/005919
(87) International publication number: WO 2023/224288

(57) **Abstract**

A battery state management apparatus according to an embodiment disclosed herein includes an information obtaining unit configured to obtain a capacity, a voltage, and a state of health (SoH) of a battery cell corresponding to a charge/discharge cycle, and a controller configured to calculate a capacity/voltage differential value (dQ/dV) corresponding to the charge/discharge cycle of the battery cell based on the capacity and the voltage, and determine a state of the battery cell based on the capacity/voltage differential value corresponding to the charge/discharge cycle and the SoH of the battery cell.

## Description

### [TECHNICAL FIELD]

### CROSS-REFERENCE TO RELATED APPLICATION

This application claims priority to and the benefit of Korean Patent Application No. 10-2022-0060637 filed in the Korean Intellectual Property Office on May 18, 2022, the entire contents of which are incorporated herein by reference.

### TECHNICAL FIELD

Embodiments disclosed herein relate to a battery state management apparatus and an operating method thereof.

### [BACKGROUND ART]

Recently, research and development of secondary batteries have been actively performed. Herein, the secondary batteries, which are chargeable/dischargeable batteries, may include all of conventional nickel (Ni)/cadmium (Cd) batteries, Ni/metal hydride (MH) batteries, etc., and recent lithium-ion batteries. Among the secondary batteries, a lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

When venting occurs in lithium-ion batteries, direct problems may occur in the batteries, such as deterioration of cell performance, the increased possibility of ignition due to leakage of an electrolyte, etc. Thus, a technique for determining whether venting occurs in the battery is required.

### [DISCLOSURE]

### [TECHNICAL PROBLEM]

Embodiments disclosed herein aim to provide a battery state management apparatus and an operating method thereof in which venting of a battery cell may be determined.

Embodiments disclosed herein aim to provide a battery state management apparatus and an operating method thereof in which venting of a battery cell may be accurately determined based on a change amount of a voltage, a capacity, etc., of the battery cell.

Technical problems of the embodiments disclosed herein are not limited to the above-described technical problems, and other unmentioned technical problems would be clearly understood by one of ordinary skill in the art from the following description.

### [TECHNICAL SOLUTION]

A battery state management apparatus according to an embodiment disclosed herein includes an information obtaining unit configured to obtain a capacity, a voltage, and a state of health (SoH) of a battery cell corresponding to a charge/discharge cycle, and a controller configured to calculate a capacity/voltage differential value (dQ/dV) corresponding to the charge/discharge cycle of the battery cell based on the capacity and the voltage, and determine a state of the battery cell based on the capacity/voltage differential value corresponding to the charge/discharge cycle and the SoH of the battery cell.

In an embodiment, the controller may be further configured to calculate a gradient of a graph based on the capacity/voltage differential value and the SoH of the battery cell and determine whether venting occurs in the battery cell based on the gradient.

In an embodiment, the controller may be further configured to calculate a difference between the capacity/voltage differential value corresponding to the charge/discharge cycle and a reference capacity/voltage differential value and calculate the gradient by matching the calculated difference to the SoH.

In an embodiment, the controller may be further configured to control to reduce a maximum value of a charge voltage of the battery cell and a charge current of the battery cell in case of a change from a first section where the gradient is maintained to a second section where the gradient increases.

In an embodiment, the controller may be further configured to determine that venting occurs in the battery cell in the case of a change from the second section to a third section where the gradient decreases.

In an embodiment, the controller may be further configured to configure the graph to match the capacity/voltage differential value to a value processed with dynamic time warping.

In an embodiment, a horizontal axis of the graph may be the SoH and a vertical axis of the graph may be the capacity/voltage differential value processed with dynamic time warping.

In an embodiment, the SoH may include an SoHQ corresponding to capacity deterioration of the battery cell.

In an embodiment, the controller may be further configured to calculate, as the SoHQ, a ratio of a charge capacity of a specific cycle to a discharge capacity of a first charge/discharge cycle.

In an embodiment, the information obtaining unit may be further configured to obtain the capacity, the voltage, and the SoH in a specific voltage section of the battery cell.

In an embodiment, the specific voltage section may be about 3.2 V to about 3.4 V.

In an embodiment, the controller may be further configured to control to reduce a maximum value of a charge voltage of the battery cell and a charge current of the battery cell in case of a change from a first section where an absolute value of an average of the gradient is a first set value or less to a second section where the absolute value of the average of the gradient is a second set value or greater.

In an embodiment, the controller may be further configured to determine that venting occurs in the battery cell in the case of a change from the second section to a third section where the absolute value of the average of the gradient decreases to a third set value or less.

An operating method of a battery state management apparatus according to an embodiment disclosed herein includes obtaining a capacity, a voltage, and a state of health (SoH) of a battery cell corresponding to a charge/discharge cycle, calculating a capacity/voltage differential value (dQ/dV) corresponding to the charge/discharge cycle of the battery cell based on the capacity and the voltage, calculating a gradient of a graph based on the capacity/voltage differential value corresponding to the charge/discharge cycle and the SoH of the battery cell, and determining whether venting occurs in the battery cell based on the gradient.

In an embodiment, the calculate of the gradient of the graph based on the capacity/voltage differential value corresponding to the charge/discharge cycle and the SoH of the battery cell may include calculating a difference between the capacity/voltage differential value corresponding to the charge/discharge cycle and a reference capacity/voltage differential value and calculating the gradient by matching the calculated difference to the SoH.

### [ADVANTAGEOUS EFFECTS]

The battery state management apparatus and the operating method thereof according to an embodiment disclosed herein may determine whether venting occurs in a specific cycle based on a capacity/voltage differential value per cycle of a battery cell.

The battery state management apparatus and the operating method thereof according to an embodiment disclosed herein may determine whether venting occurs in the battery cell based on a change amount of a capacity/voltage differential value with respect to an SoHQ per cycle of the battery cell.

The battery state management apparatus and the operating method thereof according to an embodiment disclosed herein may determine whether venting occurs in the battery cell based on a value of a specific section of the capacity/voltage differential value of the battery cell.

Moreover, various effects recognized directly or indirectly from the disclosure may be provided.

### [DESCRIPTION OF DRAWINGS]

FIG. 1 is a block diagram of a general battery pack.
FIG. 2 is a block diagram of a battery state management apparatus according to an embodiment disclosed herein.
FIG. 3 is a view showing an example of processing a capacity/voltage differential value by a battery state management apparatus, according to an embodiment disclosed herein.
FIG. 4 shows an example of determining venting of a battery cell by a battery state management apparatus according to an embodiment disclosed herein.
FIG. 5 is a flowchart of an operating method of a battery state management apparatus according to an embodiment disclosed herein.
FIG. 6 is a flowchart showing an operating method of a battery state management apparatus, according to an embodiment disclosed herein.
FIG. 7 is a block diagram showing a hardware configuration of a computing system for performing an operating method of a battery state management apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

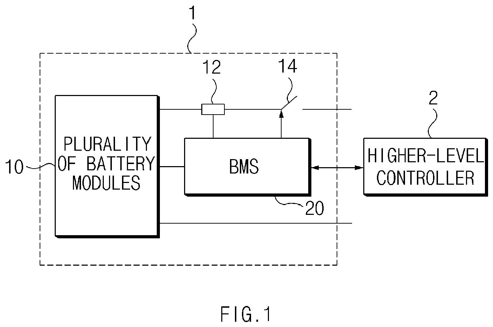

FIG. 1 is a block diagram of a general battery pack.

Referring to FIG. 1, a battery control system including a battery pack 1 and a higher-level controller 2 included in a higher-level system according to an embodiment of the present disclosure is schematically shown.

As shown in FIG. 1, the battery pack 1 may include a battery module 10 that includes one or more battery cells and is chargeable/dischargeable, a switching unit 14 serially connected to a positive (+) terminal side or a negative (-) terminal side of the battery module 10 to control a charging/discharging current flow of the battery module 10, and a battery management system 20 for control and management to prevent overcharging and over-discharging by monitoring voltage, current, temperature, etc., of the battery pack 1. The battery pack 1 may include the battery module 10, the sensor 12, the switching unit 14, and the battery management system 20 provided in plural.

Herein, as the switching unit 14 which is an element for controlling a current flow for charging or discharging of the plurality of battery modules 10, for example, at least one relay, magnetic contactor, etc., may be used according to specifications of the battery pack 1.

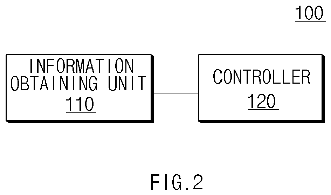

The battery management system 20, which is an interface for receiving measurement values of the above-described various parameter values, may include a plurality of terminals and a circuit, etc., connected thereto to process input values. The battery management system 20 may control on/off of the switching unit 14, e.g., a relay, a contactor, etc., and may be connected to the battery module 10 to monitor the state of each battery module 10. According to an embodiment, the battery management system 20 may include a battery state management apparatus 100 of FIG. 2. According to another embodiment, the battery management system 20 may be different from the battery state management apparatus 100 of FIG. 2. That is, the battery state management apparatus 100 of FIG. 2 may be included in the battery pack 1 and may be configured as another device outside the battery pack 1.

The higher-level controller 2 may transmit a control signal regarding the battery module 10 to the battery management system 20. Thus, the battery management system 20 may also be controlled in terms of an operation thereof based on a signal applied from the higher-level controller 2.

FIG. 2 is a block diagram of a battery state management apparatus according to an embodiment disclosed herein.

Referring to FIG. 2, the battery state management apparatus 100 according to an embodiment disclosed herein may include an information obtaining unit 110 and a controller 120. Depending on an embodiment, the battery state management apparatus 100 may be included in the battery management system 20 of FIG. 1 or may be another device that is different from the battery management system 20 of FIG. 1.

The information obtaining unit 110 may obtain a capacity, a voltage, and a SoH (state of health) of a battery cell corresponding to a charge/discharge cycle. For example, the information obtaining unit 110 may obtain a capacity, a voltage, and a SoH in a specific voltage section of a battery cell. According to an embodiment, the specific voltage section may be about 3.2 V to about 3.4 V.

According to an embodiment, the SoH may include an SoHQ corresponding to deterioration of the capacity of the battery cell.

The controller 120 may calculate a capacity/voltage differential value (dQ/dV) corresponding to a charge/discharge cycle of the battery cell based on a capacity and a voltage of the battery cell. For example, the controller 120 may calculate the capacity/voltage differential value by differentiating the capacity of the battery cell by the voltage. According to an embodiment, the controller 120 may determine whether venting of the battery cell occurs based on a capacity/voltage differential value of a specific voltage section. For example, the specific voltage section may be about 3.2 V to about 3.4 V.

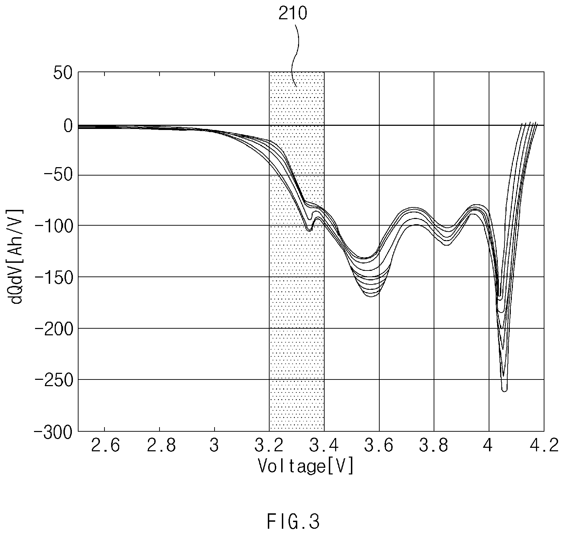

FIG. 3 is a view showing an example of processing a capacity/voltage differential value by a battery state management apparatus, according to an embodiment disclosed herein.

Referring to FIG. 3, the controller 120 may calculate a capacity/voltage differential value such as a graph shown in FIG. 3 based on a capacity and a voltage of a battery cell. For example, the information obtaining unit 110 may obtain a capacity and a voltage of a battery cell per charge/discharge cycle, and the controller 120 may calculate a capacity/voltage differential value per charge/discharge cycle.

According to an embodiment, the controller 120 may determine whether venting of the battery cell occurs based on a capacity/voltage differential value of a specific voltage section 210. For example, the specific voltage section 210 may be a discharge terminal voltage section of a battery cell. In another example, the specific voltage section may be about 3.2 V to about 3.4 V.

Referring back to FIG. 2, the controller 120 may determine a state of the battery cell based on the capacity/voltage differential value corresponding to the charge/discharge cycle and a SoH of the battery cell. For example, the controller 120 may calculate a gradient of a graph based on the capacity/voltage differential value corresponding to the charge/discharge cycle and the SoH of the battery cell. For example, the controller 120 may calculate the gradient of the graph by calculating a change amount of the capacity/voltage differential value with respect to the SoH and the charge/discharge cycle.

According to an embodiment, the controller 120 may calculate a difference between the capacity/voltage differential value corresponding to the charge/discharge cycle and a reference capacity/voltage differential value, and calculate a gradient by matching the calculated difference to the SoH. For example, the reference capacity/voltage differential value may be a capacity/voltage differential value of the battery cell before the first cycle.

According to an embodiment, the controller 120 may set the capacity/voltage differential value to correspond to a value processed by dynamic time warping. For example, the controller 120 may set a value obtained by processing the capacity/voltage differential value with dynamic time warping as a vertical axis and a SoH value as a horizontal axis to configure a graph with respect to a charge/discharge cycle.

According to an embodiment, the SoH may include an SoHQ corresponding to deterioration of the capacity of the battery cell. For example, the controller 120 may calculate, as an SoHQ, a ratio of a discharge capacity of a specific cycle to a discharge capacity of the first cycle.

According to an embodiment, the controller 120 may configure a graph based on the capacity/voltage differential value corresponding to the charge/discharge cycle and the SoHQ value corresponding to the charge/discharge cycle and determine whether venting of the battery cell occurs based on the gradient of the graph. For example, the controller 120 may calculate a difference between the capacity/voltage differential value corresponding to the charge/discharge cycle and the reference capacity/voltage differential value, set a value obtained by processing the calculated difference with dynamic time warping as a vertical axis, and set an SoHQ value as a horizontal axis to configure the graph with respect to the charge/discharge cycle.

The controller 120 may control to reduce a maximum value of a charge voltage of the battery cell and a charge current of the battery cell in case of a change from a first section where the gradient is maintained to a second section where the gradient increases. For example, the controller 120 may determine that a probability of venting occurring in the battery cell increases when the gradient increases after being maintained (in the case of the change from the first section to the second section), and thus control to reduce the maximum value of the charge voltage of the battery cell and the charge current of the battery cell to prevent venting of the battery cell from occurring. According to an embodiment, the controller 120 may set, as the first section, a section where an absolute value of an average of the gradient is less than or equal to a first set value, and as the second section, a section where the absolute value of the average of the gradient changes to a second set value or greater.

The controller 120 may determine that venting occurs in the battery cell in the case of a change from the second section to a third section where the gradient decreases. For example, when venting occurs in the battery cell, a change may occur to the third section where the gradient increasing in the second section decreases. According to an embodiment, the controller 120 may set, as the third section, a section where the absolute value of the average of the gradient is less than or equal to a third set value, from the second section where the absolute value of the average of the gradient is greater than or equal to the second set value.

According to an embodiment, the gradient may be a gradient of a graph with respect to a charge/discharge cycle by calculating a difference between the capacity/voltage differential value corresponding to the charge/discharge cycle and the reference capacity/voltage differential value, setting a value obtained by processing the calculated difference with dynamic time warping as a vertical axis, and setting an SoHQ value as a horizontal axis.

According to an embodiment, the controller 120 may learn a cycle changing from the first section to the second section. For example, the controller 120 may learn a cycle changing from the first section to the second section according to each charge/discharge condition. In this case, the controller 120 may suppress occurrence of venting of the battery cell by more precisely setting a charge/discharge condition.

According to an embodiment, the controller 120 may learn a cycle changing from the second section to the third section. For example, the controller 120 may learn a cycle changing from the second section to the third section according to each charge/discharge condition. In this case, the controller 120 may suppress occurrence of venting of the battery cell by more precisely setting a charge/discharge condition.

The battery state management apparatus 100 according to an embodiment disclosed herein may determine whether venting occurs in a specific cycle, based on a capacity/voltage differential value per cycle of the battery cell.

The battery state management apparatus 100 according to an embodiment disclosed herein may determine whether venting occurs in the battery cell based on a change amount of a capacity/voltage differential value with respect to an SoHQ per cycle of the battery cell.

The battery state management apparatus 100 according to an embodiment disclosed herein may determine whether venting occurs in the battery cell based on a value of a specific section of the capacity/voltage differential value of the battery cell.

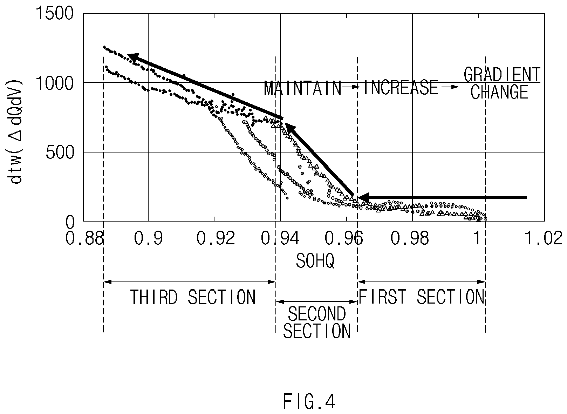

FIG. 4 shows an example of determining venting of a battery cell by a battery state management apparatus according to an embodiment disclosed herein.

Referring to FIG. 4, the controller 120 may set the SoHQ as the horizontal axis and a value obtained by processing the change amount of the capacity/voltage differential value with dynamic time warping as the vertical axis to configure the graph corresponding to the charge/discharge cycle. For example, the SoHQ may be calculated as a ratio of a discharge capacity of a specific cycle to a discharge capacity of the first cycle. In another example, the change amount of the capacity/voltage differential value may be calculated as the difference between the capacity/voltage differential value corresponding to the charge/discharge cycle and the reference capacity/voltage differential value.

The controller 120 may divide the first section where the gradient is maintained, the second section where the gradient increases, and the third section where the increasing gradient decreases. For example, the controller 120 may determine a cycle where the change occurs from the first section to the second section and a cycle where the change occurs from the second section to the third section. In this case, the controller 120 may control to reduce a maximum value of a charge voltage of the battery cell and a charge current of the battery cell from the cycle where the change occurs from the first section to the second section. In addition, the controller 120 may determine that venting occurs in the battery cell from the cycle where the change occurs from the second section to the third section.

According to an embodiment, cycles of the first section, the second section, and the third section may change with the charge/discharge condition. For example, when charge is performed with higher current or voltage (e.g., in case of fast charge), the battery cell may change from the first section to the second section and from the second section to the third section more rapidly than normal charge.

According to an embodiment, the controller 120 may learn the cycles of the first section, the second section, and the third section. For example, the controller 120 may learn the cycles of the first section, the second section, and the third section based on the charge/discharge condition.

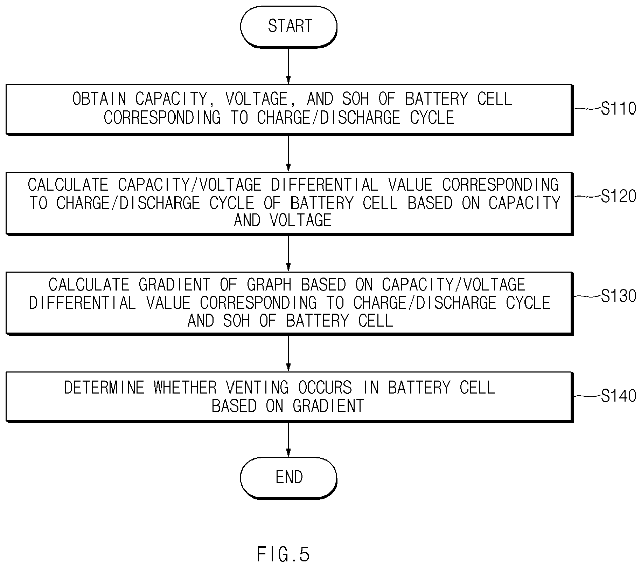

FIG. 5 is a flowchart of an operating method of a battery state management apparatus according to an embodiment disclosed herein. According to an embodiment, the operating method of the battery state management apparatus may be performed by the battery state management apparatus 100 of FIG. 2.

Referring to FIG. 5, the operating method of the battery state management apparatus 100 according to an embodiment disclosed herein may include operation S 110 of obtaining a capacity, a voltage, and an SoH of a battery cell corresponding to a charge/discharge cycle, operation S 120 of calculating a capacity/voltage differential value corresponding to the charge/discharge cycle of the battery cell based on the capacity and the voltage, operation S130 of calculating a gradient of a graph based on the capacity/voltage differential value corresponding to the charge/discharge cycle and an SoH of the battery cell, and operation S 140 of determining whether venting occurs in the battery cell based on the gradient.

In operation S110 of obtaining the capacity, the voltage, and the SoH of the battery cell corresponding to the charge/discharge cycle, the information obtaining unit 110 may obtain the capacity, the voltage, and the SoH of the battery cell corresponding to the charge/discharge cycle. For example, the SoH may include the SoHQ corresponding to deterioration of the capacity of the battery cell. According to an embodiment, the SoHQ may be calculated as a ratio of the discharge capacity of the specific cycle to the discharge capacity of the first cycle.

In operation S120 of calculating the capacity/voltage differential value corresponding to the charge/discharge cycle of the battery cell based on the capacity and the voltage, the controller 120 may calculate the capacity/voltage differential value dQ/dV corresponding to the charge/discharge cycle of the battery cell based on the capacity and the voltage. For example, the controller 120 may calculate the capacity/voltage differential value based on the capacity and the voltage of the battery cell, calculate a difference between the calculated capacity/voltage differential value and the reference capacity/voltage differential value, and process the calculated difference with dynamic time warping.

In operation S130 of calculating the gradient of the graph based on the capacity/voltage differential value corresponding to the charge/discharge cycle and the SoH of the battery cell, the controller 120 may calculate the gradient of the graph based on the capacity/voltage differential value corresponding to the charge/discharge cycle and the SoH of the battery cell. For example, the controller 120 may set a value obtained by processing the calculated difference with dynamic time warping as a vertical axis and an SoHQ as a horizontal axis to configure a graph with respect to a charge/discharge cycle. The controller 120 may calculate the gradient per charge/discharge cycle based on the configured graph.

In operation S140 of determining whether venting occurs in the battery cell based on the gradient, the controller 120 may determine whether venting occurs in the battery cell based on the calculated gradient. For example, the controller 120 may control to reduce the maximum value of the charge voltage of the battery cell and the charge current of the battery cell in case of the change from the first section where the gradient is maintained to the second section where the gradient increases, thereby preventing venting of the battery cell. Moreover, the controller 120 may determine that venting occurs in the battery cell in the case of a change from the second section to a third section where the gradient decreases. In this case, the controller 120 may transmit to a user, a notification indicating venting occurs in the battery cell and replacement of the battery cell is required.

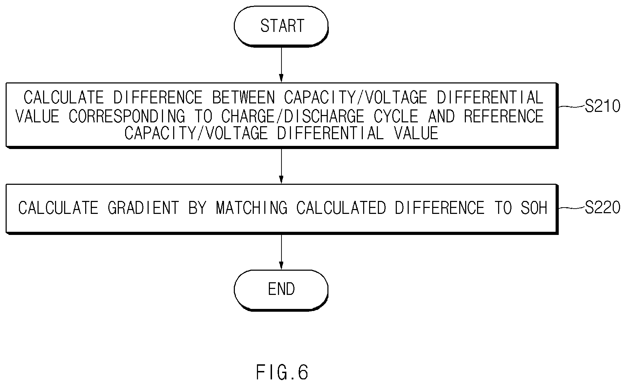

FIG. 6 is a flowchart showing an operating method of a battery state management apparatus, according to an embodiment disclosed herein.

Referring to FIG. 6, the operating method of the battery state management apparatus 100 may include operation S210 of calculating the difference between the capacity/voltage differential value corresponding to the charge/discharge cycle and the reference capacity/voltage differential value and operation S220 of calculating the gradient by matching the calculated difference to the SoH. According to an embodiment, operations S210 and S220 may be included in operation S130 of FIG. 5.

In operation S210 of calculating the difference between the capacity/voltage differential value corresponding to the charge/discharge cycle and the reference capacity/voltage differential value, the controller 120 may calculate the difference between the capacity/voltage differential value corresponding to the charge/discharge cycle and the reference capacity/voltage differential value.

In operation S220 of calculating the gradient by matching the calculated difference to the SoH, the controller 120 may calculate the gradient by matching the calculated difference to the SoH. For example, the controller 120 may calculate the gradient corresponding to the charge/discharge cycle by matching the calculated difference to the SoHQ.

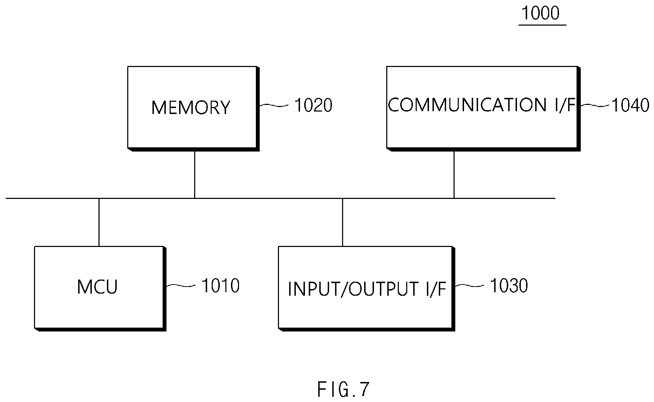

FIG. 7 is a block diagram showing a hardware configuration of a computing system for performing an operating method of a battery state management apparatus, according to an embodiment disclosed herein.

Referring to FIG. 7, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a battery cell capacity or voltage collection program, a voltage collection program, an SoH calculation program of a battery cell, a capacity/voltage differential value calculation program of the battery cell, etc.) stored in the memory 1020, processes various information including a capacity/voltage differential value or an SoHQ of a battery cell through these programs, and executes the above-described functions of the battery state management apparatus shown in FIG. 2.

The memory 1020 may store various programs regarding collection of a capacity and a voltage of a battery cell, calculation of a capacity/voltage differential value, calculation of AN SoH, etc. Moreover, the memory 1020 may store various information such as a gradient of a graph set based on a current, a voltage, a capacity, AN SoHQ, a capacity/voltage differential value, and a SoH of the battery cell, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery state management apparatus may transmit and receive, to and from a separately provided external server through the communication I/F 1040, information such as voltages, currents, SoHs, capacity/voltage differential values, a graph based on a capacity/voltage differential value and a SoH of the battery cell, a gradient of the graph, and occurrence of venting of the battery cell.

As such, a computer program according to an embodiment disclosed herein may be recorded in the memory 1020 and processed by the MCU 1010, thus being implemented as a module that performs functions shown in FIG. 2.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of the present disclosure.

## Claims

1. A battery state management apparatus comprising:
an information obtaining unit configured to obtain a capacity, a voltage, and a state of health (SoH) of a battery cell corresponding to a charge/discharge cycle; and
a controller configured to calculate a capacity/voltage differential value (dQ/dV) corresponding to the charge/discharge cycle of the battery cell based on the capacity and the voltage and determine a state of the battery cell based on the capacity/voltage differential value corresponding to the charge/discharge cycle and the SoH of the battery cell.

2. The battery state management apparatus of claim 1, wherein the controller is further configured to:
calculate a gradient of a graph based on the capacity/voltage differential value and the SoH of the battery cell; and
determine whether venting occurs in the battery cell based on the gradient.

3. The battery state management apparatus of claim 2, wherein the controller is further configured to:
calculate a difference between the capacity/voltage differential value corresponding to the charge/discharge cycle and a reference capacity/voltage differential value; and
calculate the gradient by matching the calculated difference to the SoH.

4. The battery state management apparatus of claim 2, wherein the controller is further configured to control to reduce a maximum value of a charge voltage of the battery cell and a charge current of the battery cell in case of a change from a first section where the gradient is maintained to a second section where the gradient increases.

5. The battery state management apparatus of claim 4, wherein the controller is further configured to determine that venting occurs in the battery cell in the case of a change from the second section to a third section where the gradient decreases.

6. The battery state management apparatus of claim 2, wherein the controller is further configured to configure the graph to match the capacity/voltage differential value to a value processed with dynamic time warping.

7. The battery state management apparatus of claim 6, wherein a horizontal axis of the graph is the SoH and a vertical axis of the graph is the capacity/voltage differential value processed with dynamic time warping.

8. The battery state management apparatus of claim 2, wherein the SoH comprises an SoHQ corresponding to capacity deterioration of the battery cell.

9. The battery state management apparatus of claim 8, wherein the controller is further configured to calculate, as the SoHQ, a ratio of a charge capacity of a specific cycle to a discharge capacity of a first charge/discharge cycle.

10. The battery state management apparatus of claim 1, wherein the information obtaining unit is further configured to obtain the capacity, the voltage, and the SoH in a specific voltage section of the battery cell.

11. The battery state management apparatus of claim 10, wherein the specific voltage section is 3.2 V to 3.4 V.

12. The battery state management apparatus of claim 2, wherein the controller is further configured to control to reduce a maximum value of a charge voltage of the battery cell and a charge current of the battery cell in case of a change from a first section where an absolute value of an average of the gradient is a first set value or less to a second section where the absolute value of the average of the gradient is a second set value or greater.

13. The battery state management apparatus of claim 12, wherein the controller is further configured to determine that venting occurs in the battery cell in the case of a change from the second section to a third section where the absolute value of the average of the gradient decreases to a third set value or less.

14. An operating method of a battery state management apparatus, the operating method:
obtaining a capacity, a voltage, and a state of health (SoH) of a battery cell corresponding to a charge/discharge cycle;
calculating a capacity/voltage differential value (dQ/dV) corresponding to the charge/discharge cycle of the battery cell based on the capacity and the voltage;
calculating a gradient of a graph based on the capacity/voltage differential value corresponding to the charge/discharge cycle and the SoH of the battery cell; and
determining whether venting occurs in the battery cell based on the gradient.

15. The operating method of claim 14, wherein the calculate of the gradient of the graph based on the capacity/voltage differential value corresponding to the charge/discharge cycle and the SoH of the battery cell comprises:
calculating a difference between the capacity/voltage differential value corresponding to the charge/discharge cycle and a reference capacity/voltage differential value; and
calculating the gradient by matching the calculated difference to the SoH.
